# EUROPEAN PATENT APPLICATION

(11) **EP 1 918 977 A2**
(43) Date of publication of application: **07.05.2008**
(21) Application number: 07014340.9
(22) Date of filing: 20.07.2007
(51) Int. Cl.: H01L 21/00

(54) **Workpiece rotation apparatus for a plasma reactor system**

(30) Priority: 30.10.2006 US 589498
(71) Applicant: Applied Materials, Inc., Santa Clara, CA 95054 (US)
(72) Inventor: Lewington, Richard, Hayward CA 94544 (US); Nguyen, Khiem K., San Jose CA 95148 (US); Kumar, Ajay, Cupertino CA 95014 (US); Ibrahim, Ibrahim M., Santa Clara CA 95054 (US); Chandrachood, Madhavi R., Sunnyvale CA 94086 (US); Anderson, Scott Alan, Livermore CA 94551 (US)
(74) Representative: Zimmermann, Gerd Heinrich

(57) **Abstract**

A plasma processing system (100) for processing a planar workpiece is provided that has the capability of changing the rotational position of a workpiece relative to a plasma processing chamber of the system. The system workpiece transfer apparatus is coupled to the reactor chambers (102, 104, 106, 108) of the system. The workpiece transfer apparatus is capable of transferring workpieces to and from each of the chambers. The system further includes a factory interface (120) coupled to the workpiece transfer apparatus for transferring workpieces from and to a factory environment external of the plasma processing system. The factory interface includes (a) a frame defining an internal volume, (b) a rotatable and translatable arm (134) supported on the frame within the internal volume, (c) a workpiece-handling blade (126) attached to an outer end of the arm, and (d) a stationary workpiece-holding support bracket (140, 160) that facilitates rotation of a workpiece.

## Description

The present invention generally relates to plasma processing systems. In particular it relates to plasma processing systems with improved processing uniformity. More specifically, it relates to a plasma processing system for processing a planar workpiece, a mask rotation bracket, and a method of rotating the position of a workpiece in a chamber.

Fabrication of photolithographic masks for use in processing of ultra large scale integrated (ULSI) semiconductor wafers requires a much higher degree of etch uniformity than semiconductor wafer processing. A single mask pattern generally occupies a four inch square area on a quartz mask. The image of the mask pattern is focused down to the area of a single die (a one inch square) on the wafer and is then stepped across the wafer, forming a single image for each die. Prior to etching the mask pattern into the quartz mask, the mask pattern is written in photoresist by a scanning electron beam, a time consuming process which renders the cost of a single mask extremely high. The mask etch process is not uniform across the surface of the mask. Moreover, the e-beam written photoresist pattern is itself nonuniform, and exhibits, in the case of 45 nm feature sizes on the wafer, as much as 2-3 nm variation in critical dimension (e.g., line width) across the entire mask. (This variation is the 3σ variance of all measured line widths, for example.) Such non-uniformities in photoresist critical dimension typically varies among different mask sources or customers. The mask etch process cannot increase this variation by more than 1 nm, so that the variation in the etched mask pattern cannot exceed 3-4 nm. These stringent requirements arise from the use of diffraction effects in the quartz mask pattern to achieve sharp images on the wafer. There is a continuous demand for improvement in the mask etch process.

In light of the above, the plasma processing system according to independent claim 1, the mask rotation bracket according to independent claim 17, and the method for a plasma processing apparatus according to independent claim 21 are provided.
We have discovered that one way of improving uniformity of the etched patterns in the mask would be to rotate the mask before completion of a mask etch process. For example, when a particular etch step is half-completed, the etch process would be halted (plasma turned off and process gas injection halted), the mask removed from the plasma reactor chamber and rotated 180 degrees and returned back into the chamber, and the plasma etch process resumed until completed. The problem is that the mask-handling apparatus, including robotic arms and blades, are not capable of changing the rotational orientation of the mask as it is transferred from or to any of the chambers, without prohibitively expensive modifications or adaptation. That is, even though the robotic arms and blades themselves can rotate (in some cases by as much as 360 degrees), they cannot produce a net change in the mask orientation relative to any of the chambers because, as soon as the robotic blade picks up a mask, its rotational orientation relative to each of the chambers is fixed. This is because each time the blade fetches or deposits a mask out of or into any one of the chambers, it grasps the mask by the same edge always. Since each chamber typically has only a single slit valve through which the mask can be introduced into the chamber, the direction of mask ingress and egress is always the same, and therefore no net major change in mask rotational orientation is possible as long as the blade always grasps the mask by the same edge. Therefore, a rotation of the mask through 90 degrees or 180 degrees requires intervention to remove the mask from the processing system including the automatic mask-handling apparatus, followed by manual user rotation the mask. Such intervention would necessarily include suspension of the mask processing in the plasma reactor, removal of the mask from the entire system, manual rotation of the mask at some different external location, and then re-introduction of the mask back into the processing system, re-starting of the plasma process, and so forth. Such intervention can introduce productivity losses and uncertainties into the mask fabrication process, and is not practical.

According to one aspect of the present invention, a plasma processing system for processing a planar workpiece is provided that has the capability of changing the rotational position of a workpiece relative to a plasma processing chamber of the system. The system workpiece transfer apparatus coupled to the reactor chambers of the system. The workpiece transfer apparatus is capable of transferring workpieces to and from each of the chambers. The system further includes a factory interface coupled to the workpiece transfer apparatus for transferring workpieces from and to a factory environment external of the plasma processing system. The factory interface includes (a) a frame defining an internal volume, (b) a rotatable and translatable arm supported on the frame within the internal volume, (c) a workpiece-handling blade attached to an outer end of the arm, and (d) a stationary workpiece-holding support bracket. The bracket includes a support edge fastened on the frame and extending into the internal volume of the frame and defining a workpiece support plane. The bracket further includes first and second workpiece transfer edges at different portions of a periphery of the bracket. The workpiece-handling blade is capable of depositing a workpiece onto the bracket and removing a workpiece from the bracket at respective ones of the first and second workpiece transfer edges of the bracket. Rotation of the workpiece relative to the system is made possible by embodiments of the present invention.
Further advantages, features, aspects and details of the invention are evident from the dependent claims, the description and the drawings.
Embodiments are also directed to apparatuses for carrying out the disclosed methods and including apparatus parts for performing described method steps. Furthermore, embodiments are also directed to methods by which the described apparatus operates. It may include method steps for carrying out functions of the apparatus. The method steps may be performed by way of hardware components, firmware, a computer programmed by appropriate software, by any combination thereof or in any other manner.

So that the manner in which the exemplary embodiments of the present invention are attained and can be understood in detail, a more particular description of the invention, briefly summarized above, may be had by reference to the embodiments thereof which are illustrated in the appended drawings. It is to be appreciated that certain well known processes are not discussed herein in order to not obscure the invention.
The invention will be better understood by reference to the following description of embodiments taken in conjunction with the accompanying drawings, wherein:

FIG. 1 is a top view of a plasma processing system having plural plasma reactor chambers and automated workpiece-handling capability.

FIG. 2 is a perspective view of a factory interface in the system of FIG. 1.

FIG. 3 is a top view corresponding to FIG. 2.

FIG. 4 is a perspective view of mask rotation brackets in the factory interface of FIGS. 2 and 3.

FIG. 5 is a perspective view of a typical corner post of one of the brackets of FIG. 4.

FIG. 6 is a side view of the post of FIG. 5 depicting capture of a mis-aligned mask.

FIG. 7 is a side view of the post of FIG. 5 depicting final alignment of the mask.

To facilitate understanding, identical reference numerals have been used, where possible, to designate identical elements that are common to the figures. It is contemplated that elements and features of one embodiment may be beneficially incorporated in other embodiments without further recitation. It is to be noted, however, that the appended drawings illustrate only exemplary embodiments of this invention and are therefore not to be considered limiting of its scope, for the invention may admit to other equally effective embodiments.

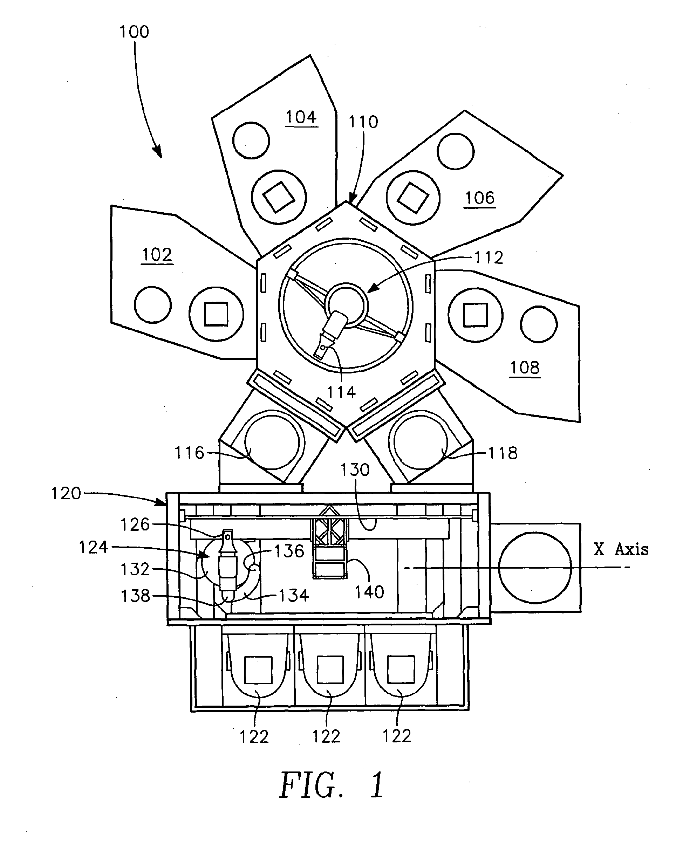

Referring to FIG. 1, a plasma processing system 100 of the type, for example, sold under the trademark "TETRA II" by Applied Materials, Inc., of Santa Clara, California, can support four plasma reactor and process chambers 102, 104, 106, 108. Such a system can be used to process semiconductor wafers or transparent (e.g., quartz) masks used in photolithographic processing of the wafers. The present invention primarily concerns application of such a system to mask fabrication for which uniformity and process tolerances are so much tighter. However, the invention may be adapted to wafer fabrication. In view of one application of the invention to mask fabrication, the workpiece is referred to as a "mask" throughout the description that follows, although this is not intended to limit the invention. For example, the workpiece may be either a transparent mask or a semiconductor wafer. It is to be appreciated that in other types of processing chambers (e.g., a deposition or an etching chamber), the workpiece can be a semiconductor wafer or substrate instead of a mask, and the embodiments of the present invention are similarly applicable thereto.

Automatic mask transport between each of the chambers 102-108 and the external (factory) environment is provided. For this purpose, a mask transfer chamber 110 is in communication with the mask slit valves (not shown) of each of the chambers 102-108 and has a robotically controlled actuator 112 with a mask-holding blade 114 capable of performing rotational, radial and axial motion. The process chambers 102-108 and the mask transfer chamber 110 are maintained at vacuum pressure. In order to facilitate transfer of masks to and from an external environment which is at atmospheric pressure, a pair of load locks 116, 118 are provided with which the actuator/blade 112, 114 can transfer masks. Each load lock 116, 118 can be pumped down to vacuum pressure and then vented up to atmospheric pressure.

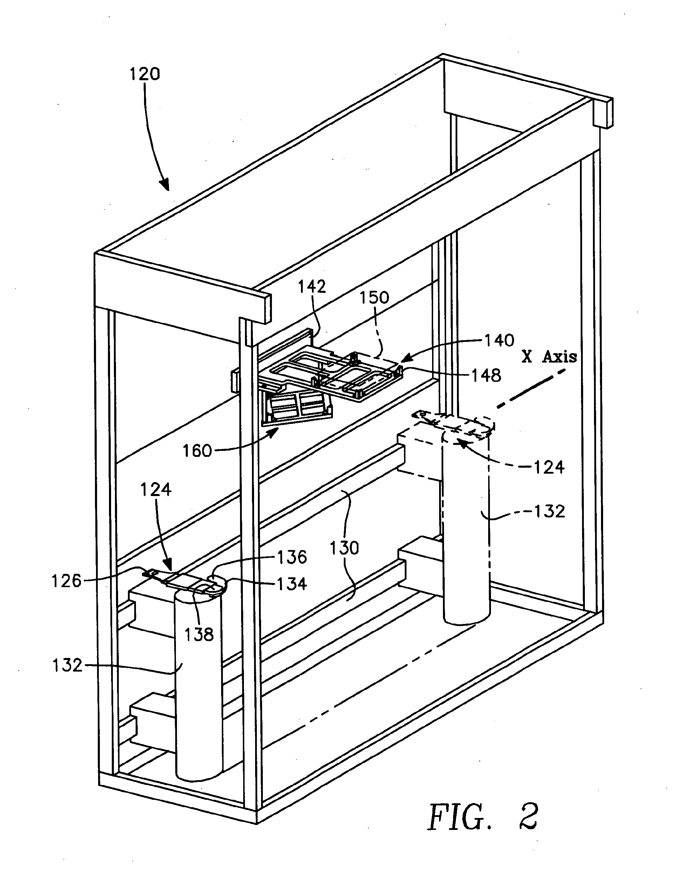

The system of FIG. 1 further includes a factory interface 120 shown in FIGS. 2, 3 and 4. The factory interface 120 is at atmospheric pressure and can support as many as six loaders 122, although typically only three are used in mask fabrication. Each one of the loaders 122 holds one or more masks to be taken into the processing system 100 or removed from it. The factory interface 120 can accept masks from or provide masks to the load locks 116, 118. For this purpose, the factory interface 120 includes a robotically controlled actuator 124 with a mask-holding blade 126. The mask-holding blade 126 can lift a mask from one of the loaders 122 and deposit it in one of the load locks 116, 118, or lift a mask from one of the load locks 116, 118 and deposit it in one of the loaders 122. The robotically controller actuator 124 can translate the blade 126 along a rail 130 extending the length of the factory interface 120 parallel to its major or "X" axis. The actuator 124 can elevate or lower the blade 126 using a lifter 132. The actuator 124 can rotate and radially extend the blade 126 using an arm 134 mounted to the lifter 132 at a first rotational joint 136 and mounted to the blade 126 at a second rotational joint 138. The width and depth of the factory interface 120 is sufficient to permit the blade 126 to rotate at least 180 degrees without interference. In all the foregoing mask transport steps or operations, the placement by the robotic blades 114 and 126 of the mask in a loader 122 or in a load lock 116 or 118 or on a wafer support pedestal in a chamber must be consistent and accurate to within a few micrometers to avoid distortion of the mask pattern. Thus, the system is vulnerable to mask-placement variations that may occur initially when the masks are first placed in a loader 122 prior to introduction to the factor interface 120.

Even though the robotic arms and blades 114, 126 can rotate (in some cases by as much as 360 degrees), they cannot produce a net change in the mask orientation relative to any of the chambers 102-108 because, as soon as the robotic blade picks up a mask, its rotational orientation relative to each of the chambers is fixed. This is because each time the blade (e.g., 126) fetches or deposits a mask out of or into any one of the chambers 102-108, it grasps the mask by the same edge always. Since each chamber 102-108 typically has only a single slit valve through which the mask can be introduced into the chamber, the direction of mask ingress and egress is always the same, and therefore no net major change in mask rotational orientation is possible as long as the blade always grasps the mask by the same edge.
Therefore, a rotation of the mask through 90 degrees or 180 degrees requires intervention to remove the mask from the processing system 100 including the automatic mask-handling apparatus, followed by manual user rotation the mask.

The embodiments of the present invention transform the system of FIG. 1 into one capable of performing fully automatic rotation of a mask by either (or both) 90 degrees or 180 degrees. The embodiments of the present invention also provide the system with the capability of automatically correcting mask placement variations or errors introduced prior to introduction of the mask(s) to the factory interface 120. The embodiments of the present invention accomplish all these features without any costly modification to the system of FIG. 1.

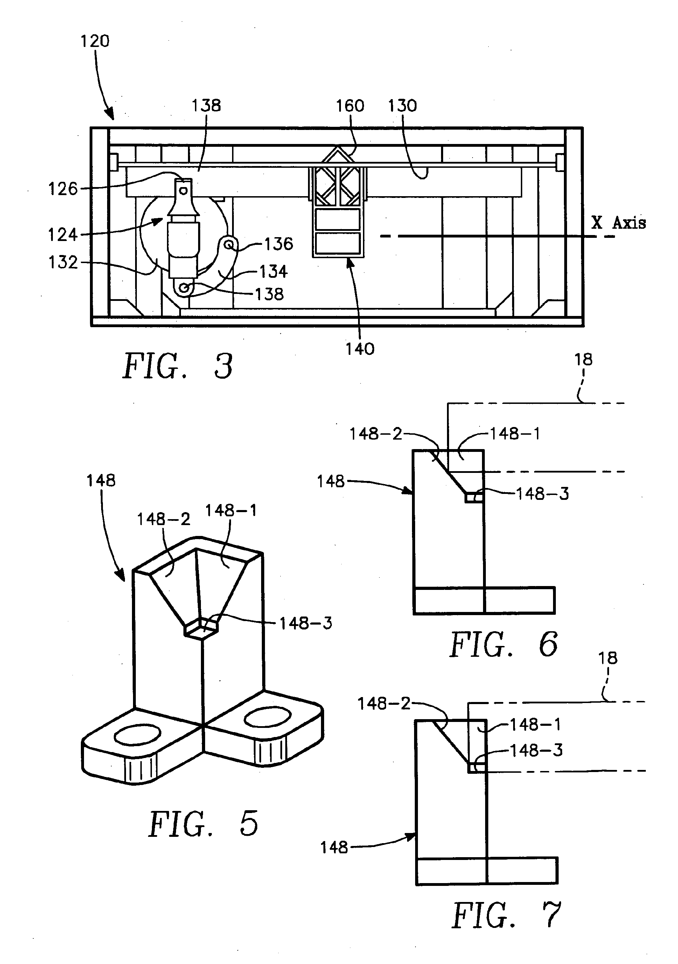

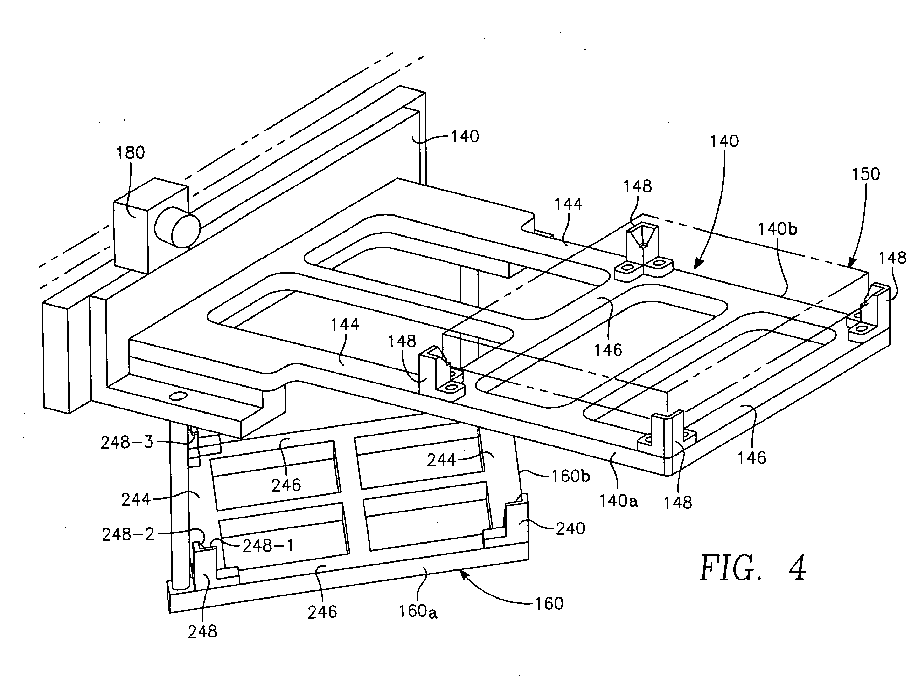

A mask bracket 140 for 180 degree mask rotation is visible in FIGS. 1-3 but is best shown in FIG. 4. The bracket 140 is supported on and cantilevered from an internal frame 142 in the interior of the factory interface 120. The bracket 140 consists of a pair of main rails 144 and cross rails 146. The main and cross rails 144, 146 together define an imaginary support plane. The bracket 140 has four posts 148 extending from the main rails 144 in a direction perpendicular to the support plane, which direction shall be referred to herein as "vertical" for the sake of simplicity but without limiting potential applications of the invention. In one embodiment, this vertical direction is parallel to the direction of gravity, for the sake of convenience, as will be explained below. The four posts 148 define a rectangle or square (depending upon the required mask shape) whose four corners coincide with the posts 148. An individual post 148 is illustrated in the enlarged view of FIG. 5. Each of the posts 148 has a pair of internal corner surfaces 148-1, 148-2 that are generally orthogonal to one another and form a right angled corner when viewed from the top along the vertical direction. Each of these wall surfaces 148-1, 148-2 is slanted from the top down to the bottom toward the interior of the rectangle formed by the four posts 148. This slant is relative to the vertical direction referred to above. The wall surfaces 148-1, 148-2 form a right-angle corner into which a corner of a rectangular mask can fit, in the manner depicted in FIG. 4. The four posts 148 are spaced apart so that the four corners of the mask 150 nest firmly into the four corners of the posts 148 when the mask rests on the bottom floor 148-3 bounded by the corner surfaces 148-1, 148-2. The force of gravity pulls the mask 150 down to the floor 148-3 of each post 148 as it slides down the slanted corner surfaces 148-1, 148-2. The mask rests on the robot blade 126 until the bottom surface 148-3 of the post 148 is reached. This keeps the vertical speed down and ensures a smooth handoff. Gravity keeps the mask on the blade 126 while the angled surfaces 148-2, 148-3 nudge it sideways.

In one embodiment, the four posts 148 reduce or even eliminate an initial misalignment problem sometimes seen in aligning a mask while the mask is being held in one of the loaders 122. This misalignment may arise from a very slight rotation or translation of the mask within the loader 122 from its proper location. As described above, the corner surfaces 148-1, 148-2 are tilted inwardly from top to bottom at slight angles relative to the true vertical direction, as shown in FIG. 5. In this way, the tops of the four posts 148 define a rectangular area that is slightly larger than the mask 150 and the bottoms of the four posts 148 define a slightly smaller rectangular area that corresponds precisely with the area of the mask 150. This feature permits a slightly misplaced mask, as it is lowered onto the four posts 148, to be captured by the top of the interior surfaces of the posts 148, as depicted in FIG. 6. Once this occurs, gravity gently impels the edge of the mask 150 down the sloping interior post surfaces until it contacts the bottom surface 148-3, as depicted in FIG. 7. At this point, all four corners of the mask have settled to the corner floor 148-3 of each of the four posts 148, and the mask 150 is perfectly aligned.

The bracket 140 is a 180 degree rotation bracket and is used by the robotic actuator/blade 124, 126 to automatically rotate the mask 150 using the following procedure: the mask 150, which may have been previously removed from one of the chambers 102-108 and placed in the load lock 116, is lifted out of the load lock 116 by the blade 126 and taken into the factory interface 120. At this point, the position of the blade 126 corresponds to its depiction in solid line in FIG. 2. The blade 126, while holding the mask 150, is rotated through a 90 degree angle from a direction facing the loader 116 to direction along the major or "X" axis of the factory interface 120. The blade 126 then translates along the X axis toward a first side 140a (FIG. 4) of the bracket 140, e.g., from left to right in the view of FIG. 1. The blade 126 drops the mask 150 onto the bracket 140, with the mask corners aligned with the four posts 148 of the bracket 140. The blade 126 is then retracted away from the bracket and lowered below the level of the bracket 140, and is translated further along the X axis in the same direction until it is past the bracket 140. The blade 140 is then rotated until it points in the opposite direction along the X axis. At this point, the position of the blade 126 corresponds to its depiction in dashed line in FIG. 2. The blade 126 is then elevated to a level at which it can capture the mask 150 that is currently sitting on the bracket 140. The blade 126 is translated in the opposite direction (e.g., from right to left in the view of FIG. 1) along the X axis toward the opposite side 140b (FIG. 4) of the bracket 140 to pick up the mask 150. The blade 126 therefore picks up the mask 150 on the opposite side from which it had deposited the mask on the bracket 140, and delivers the mask 150 to the load lock 116. This completes a 180 degree rotation of the mask 150 from its initial orientation. From the load lock 116, the mask 150 is taken by the load lock's robotically actuated blade 114 to one of the chambers 102-108 for completion of the etch process.

90 degree rotation of the mask 150 can be performed using another bracket 160 also shown in FIG. 4. The 90 degree rotation bracket 160 is supported on the internal frame 142 in the interior of the factory interface 120. The bracket 160 consists of a pair of main rails 244, cross rails 246 which together with the main rails 244 define a support plane. Four posts 248, similar to the posts 148 of the 180 degree rotation bracket 140, extend from the main rails 244 in a direction perpendicular to the support plane. Each of the posts 248 has a pair of mutually orthogonal walls 248-1, 248-2 that are perpendicular to the support plane and form a corner into which a corner of a mask can nest. The four posts 248 are spaced apart so that the four corners of the mask 150 nest firmly into the four corners of the posts 248. The four posts define a rectangle oriented at a 45 degree angle relative to the major or X axis of the factory interface 120. Moreover, the bracket 160 has one corner that abuts a boundary of the factor interface 120 so as to provide a maximum distance to the opposite boundary of the factory interface, in order to provide maximum room for an approach by the robot blade 126, as will be described below. In one, the posts 248 extend vertically up so that the force of gravity pulls the mask directly down to the floor 248-3 of each post 248. The mutually orthogonal walls 248-1, 248-2 have interior surfaces which are tilted inwardly from top to bottom at slight angles relative to the true vertical direction. This feature permits a slightly misplaced mask, as it is lowered onto the four posts 248, to be captured by the top of the interior surfaces of the posts 248. Once this occurs, gravity gently impels the edge of the mask 150 edge down the sloping interior post surfaces until it contacts the bottom surface 248-3, at which point the mask 150 is perfectly aligned.

The bracket 160 is a 90 degree rotation bracket and is used by the robotic actuator/blade 124, 126 to automatically rotate the mask 150 by 90 degrees using the following procedure in which the mask is (a) deposited on the bracket 160 by the blade 126 approaching a first side 160a of the bracket and then (b) removed from the bracket by the blade 126 approaching a second side 160b of the bracket that is adjacent and orthogonal to the first side 160a. The procedure is carried out as follows: the mask 150, which may have been previously removed from one of the chambers 102-108 and placed in the load lock 116, is lifted out of the load lock 116 by the blade 126 and taken into the factory interface 120. The blade 126 is rotated from a direction facing the loader 116 to a direction oriented 45 degrees relative to the major axis X of the factory interface 120, so as to face the first side 160a of the bracket 160. The blade 126 then translates along the X axis toward the first bracket side 160a (e.g., from left to right in the view of FIG. 1). The blade 126 drops the mask 150 onto the bracket 160, with the mask corners aligned with the four posts 248 of the bracket 160. The blade 126 is then retracted away from the bracket 160 and lowered below the level of the bracket 160, and is then translated further along the X axis in the same direction until it is past the bracket 160. The blade 126 is then rotated 90 degrees, e.g., until it points in the opposite direction at a 45 degree angle relative to the X axis, so that it faces the second (adjacent) side 160b of the bracket 160. The blade 126 is then elevated to a level at which it can capture the mask 150 sitting on the bracket 160. The blade 126 is then translated in the opposite direction (e.g., from right to left in the view of FIG. 1) along the X axis toward the adjacent side 160b of the bracket 160 to pick up the mask 150. The blade 126 therefore picks up the mask 150 on the adjacent side from which it had deposited the mask on the bracket 140, and delivers the mask 150 to the load lock 116. This completes a 90 degree rotation of the mask 150 from its initial orientation. From the load lock 116, the mask 150 is taken by the load lock's robotically actuated blade 114 to one of the chambers 102-108 for completion of the etch process.

A camera 180 may be provided beneath the mask 150 on the bracket 140 (and/or on the bracket 160). The camera 180 is adapted to sense a legend written on a deposited photoresist film on the mask 150 or etched on the mask 150. A processor associated with the camera 180 is programmed to perform optical character recognition to generate a string of characters in text form representing the printed legend. This string of characters may represent a process sequence for the particular mask, which information is forwarded to a process controller governing the system 100. This information may define which one of the chambers 102-108 to place the mask 150 and which process is to be performed, for example.

While the foregoing is directed to embodiments of the present invention, other and further embodiments of the invention may be devised without departing from the basic scope thereof, and the scope thereof is determined by the claims that follow.

## Claims

1. A plasma processing system (100) for processing a planar workpiece, comprising:
plural plasma reactor chambers (102, 104, 106, 108);
workpiece transfer apparatus (112, 114) coupled to said plural reactor chambers capable of transferring workpieces to and from each of said chambers; and
a factory interface (120) coupled to said workpiece transfer apparatus for transferring workpieces from and to a factory environment external of said plasma processing system, said factory interface comprising:
(a) a frame defining an internal volume;
(b) a rotatable and translatable arm (134) supported on said frame within said internal volume;
(c) a workpiece-handling blade (126) attached to an outer end of said arm;
(d) a stationary workpiece-holding support bracket (140, 160) comprising a support edge fastened on said frame and extending into said internal volume of said frame and defining a workpiece support plane, said bracket further comprising first and second workpiece transfer edges (140a, 140b, 160a, 160b) at different portions of a periphery of said bracket.

2. The system of Claim 1 wherein said workpiece-handling blade (126) is capable of depositing a workpiece onto said bracket (140, 160) and removing a workpiece from said bracket at respective ones of said first and second workpiece transfer edges of said bracket.

3. The system of any of Claims 1 to 2,wherein said bracket (140) is a 180 degree workpiece rotation bracket and said different portions of said periphery of said bracket comprise opposing portions of said periphery of said bracket.

4. The system of Claim 3 wherein the workpiece support plane defined by said bracket is a rectangle or square, and wherein said opposing portions of said periphery are opposite edges that are parallel to one another and face opposing portions of said internal volume of said frame of said factory interface (120).

5. The system of Claim 4 wherein said internal volume of said frame of said factory interface has a narrow dimension and a long dimension orthogonal to said narrow dimension, said factory interface frame comprising a pair of opposing long sides corresponding to said long dimension and separated by said narrow dimension, said long sides facing, respectively, said wafer transfer apparatus and the factory environment.

6. The system of Claim 5 wherein said opposing edges of said bracket (140) face opposite directions within said internal volume along said long dimension of said frame.

7. The system of Claim 6 wherein said narrow dimension restricts rotation of said arm (134) while holding a workpiece to a rotation of less than a 90 degree rotation.

8. The system of any of Claims 1 to 2, wherein said bracket (160) is a 90 degree workpiece rotation bracket and said different portions of said periphery of said bracket comprise adjacent portions of said periphery of said bracket.

9. The system of Claim 8 wherein the workpiece support plane defined by said bracket is a rectangle or square, and wherein said opposing portions of said periphery are adjacent edges that are orthogonal to one another.

10. The system of Claim 9 wherein said internal volume of said frame of said factory interface (120) has a narrow dimension and a long dimension orthogonal to said narrow dimension, said factory interface frame comprising a pair of opposing long sides corresponding to said long dimension and separated by said narrow dimension, said long sides facing, respectively, said wafer transfer apparatus and the factory environment.

11. The system of Claim 10 wherein said adjacent edges of said bracket lie along respective 45 degree angles relative to said long dimension of said frame.

12. The system of Claim 11 wherein said narrow dimension restricts rotation of said arm (134) while holding a workpiece to a rotation of less than a 90 degree rotation, said narrow dimension being sufficient to permit a 45 degree rotation of said arm while holding a workpiece.

13. The system of any of Claims 1 to 12, wherein said bracket (140, 160) further comprises:
support arms generally parallel to said workpiece support plane; and
plural posts (148) extending from said support arms to said workpiece support plane.

14. The system of any of Claims 1 to 13 wherein each of said posts (148) comprises a first top edge above said workpiece support plane and a floor (148-3) at said workpiece support plane and at least a first slanted workpiece alignment wall (148-1, 148-2) sloping downwardly from said top edge to said floor toward a center or interior point of said support plane.

15. The system of Claim 14 wherein the workpiece alignment walls of said plural posts (148) confine said workpiece support plane to dimensions corresponding to the size of said workpiece.

16. The system of Claim 15 wherein said workpiece support plane is rectangular or square, and each post further comprises a second top edge orthogonal to said first top edge, and a second slanted workpiece alignment wall (148-1, 148-2) sloping downwardly from said second top edge to said floor (148-3), said first and second top edges meeting at a right angle corner.

17. A mask rotation bracket (140, 160) for attachment in the interior of a mask transport apparatus, comprising:
support struts beneath a workpiece support plane and having a periphery;
first and second workpiece transfer edges (140a, 140b, 160a, 160b) at different portions of said periphery;
a support edge attachable onto an interior surface of said mask transport apparatus; and
plural posts (148) extending from said support struts to said workpiece support plane.

18. The mask rotation bracket of Claim 17 wherein each of said posts (148) comprises a first top edge above said workpiece support plane and a floor (148-3) at said workpiece support plane and at least a first slanted workpiece alignment wall (148-1, 148-2) sloping downwardly from said top edge to said floor toward a center or interior point of said support plane.

19. The mask rotation bracket of Claim 18 wherein the workpiece alignment walls of said plural posts (148) confine said workpiece support plane to dimensions corresponding to the size of said workpiece.

20. The mask rotation bracket of Claim 19 wherein said workpiece support plane is rectangular or square, and each post further comprises a second top edge orthogonal to said first top edge, and a second slanted workpiece alignment wall sloping downwardly from said second top edge to said floor (148-3), said first and second top edges meeting at a right angle corner.

21. In a plasma processing apparatus having automated workpiece-handling apparatus including a movable workpiece-handling arm (134/126) and at least one plasma reactor chamber, a method of rotating the position of a workpiece in the chamber, comprising:
providing in the wafer-handling apparatus a stationary workpiece-holding bracket (140, 160) that extends into an interior volume of the wafer-handling apparatus;
removing a workpiece from the chamber and, with said workpiece-handling arm (134/126) holding said workpiece, approaching a first side (140a, 140b, 160a, 160b) of said bracket (140, 160) with a workpiece-grasping end of said arm facing said first side, and depositing the workpiece onto the bracket;
moving the workpiece-handling arm to another second side (140a, 140b, 160a, 160b) of said bracket while leaving said workpiece on said bracket, rotating said workpiece handling arm until the workpiece-grasping end faces said second side of said bracket; and
approaching said bracket by said arm and removing said workpiece from said bracket with said arm and returning said workpiece to said chamber.

22. The method of Claim 21 wherein said bracket is a 180 degree rotation bracket and the step of rotating said workpiece-handling arm comprises a rotation through 180 degrees.

23. The method of Claim 21 wherein said bracket is a 90 degree rotation bracket and the step of rotating said workpiece-handling arm comprises a rotation through 90 degrees.
